# EUROPEAN PATENT APPLICATION

(11) **EP 4 576 623 A1**
(43) Date of publication of application: **25.06.2025**
(21) Application number: 23218956.3
(22) Date of filing: 21.12.2023
(51) Int. Cl.: H04L 1/00, H03M 13/09, H03M 13/37

(54) **METHOD AND SYSTEM FOR ERROR DETECTION AND CORRECTION BASED ON CRC CODES**

(71) Applicant: ABB Schweiz AG, 5400 Baden (CH)
(72) Inventor: Pang, Zhibo, 72240 Vasteras (SE); Zhan, Ming, 400715 Chongqing (CN)
(74) Representative: Patentanwälte Pinter & Weiss OG

(57) **Abstract**

The present invention relates to a method and a system for detecting and correcting errors in safety messages and/or safety-relevant data received by an automation component (A1, A2) of an industrial automation system via a digital communication network, especially a fieldbus communication system, wherein a safety protocol, which is implemented by means of a Safety communication layer (SCL), is used for data transmission of the safety messages and/or safety-relevant data, wherein Cyclic Redundancy Checks are applied to the safety messages and/or safety-relevant data, and wherein the safety messages and/or safety-relevant data are transmitted in the form of data packets (DP, DP1, DP2). An Error correction layer (ECL), which is inserted on the receiver's (A1, A2) side between the Safety communication layer (SCL) and underlying communication layers (CL) of the communication network, is designed to carry out the following steps to detect and correct errors in the safety messages and/or safety-relevant data. First a data packet (DP, DP1, DP2), which is received by the automation component (A1, A2) via the communication network, is retrieved from a receiving part (REC) of communication layers (CL) of the communication network (101). Then an error pattern (EP) is generated by an Error pattern generator unit (EPG) (102). Then a logical operation is applied to the received data packet (DP, DP1, DP2) and the generated error pattern (EP) by a Bit string calculator unit (BSC), wherein an updated data packet (DP') is determined as result (103). Then the updated data packet (DP') is checked for errors using Cyclic Redundancy Check according to a given CRC polynomial (CP) by an Error detector unit (ED) and an error signal (CRC_E) is set to a value, whether there is at least one error in the updated data packet (DP') or not (104). The value of the error signal (CRC_E) is evaluated and a number of repetitions of the steps of error pattern generation, determining an updated data packet (DP'), checking the updated data packet (DP') for errors and evaluating the error signal (CRC_E) is monitored by an Error correction control unit (ECC). These steps are repeated, until either the value of the error signal (CRC_E) indicates that the updated data packet (DP') is error-free or the number of repetitions of these steps reaches a predefined maximum number of repetitions.

## Description

### TECHNICAL FIELD OF THE INVENTION

The present invention relates to a method for detecting and correcting errors in safety messages and/or safety-relevant data received by an automation component of an industrial automation system via a digital communication network, especially a fieldbus communication system, wherein a safety protocol, which is implemented by means of a Safety communication layer, is used for data transmission of the safety messages and/or safety-relevant data, wherein Cyclic Redundancy Checks are applied to the safety messages and/or safety-relevant data, and wherein the safety messages and/or safety-relevant data are transmitted in the form of data packets. Furthermore, the present invention relates to a system for carrying out the method for error detection and correction in safety messages and/or safety-relevant data.

### BACKGROUND INFORMATION

Today's industrial automation systems comprise numerous automation components, such as sensors, actuators, switches, valves, contactors, machines or machine components, controllers, communication gateways, computers and network components, etc., to monitor, control and regulate technical processes, especially in the field of machine automation, robotics, process automation and/or factory automation or for the automation of powertrains and/or electrical systems. These automation components are networked together via digital communication networks to provide data collection, exchange of data and messages and analysis. The digital communication networks used can be wired and/or wireless communication networks. The connection of the automation components enables companies to pick up on inefficiencies and problems sooner. Data are collected from sensors, machines or machine component, which may be widely distributed within the automation system, transmitted via the digital communication network to control units for analysis and command messages are delivered back to actuators, switches, valves, contactors, etc. via the digital communication network, after data processing in the control unit. This may enable the operation of an automation system, which should be as autonomous and independent of human intervention as possible.

Since the data communication within industrial automation systems is often time-critical and high availability is required, fieldbus communication systems are often used. Additionally, special communication protocols tailored to industrial automation are applied, like e.g., the Industrial Ethernet protocols, which include PROFINET, POWERLINK, EtherNet/IP, EtherCAT, etc. These often-standardized protocols are created based on the reference model ISO/OSI, wherein they usually use the Physical Layer (Layer 1), the Data Link Layer (Layer 2) and the Application Layer (Layer 7) of the seventh-layer architecture of the ISO/OSI-model.

Although the usage of communication protocols, like PROFINET, POWERLINK, EtherNet/IP, EtherCAT, etc., is essential for seamless data exchange over the fieldbus communication systems and for control in industrial automation systems, these protocols alone are not suitable for the transmission of safety-critical data and/or safety messages. They cannot ensure functional safety of an automation system, e.g., as defined by the international norm IEC 61508. Functional Safety is a part of the overall safety of a system, like an automation system, or a part of a system (e.g., a machine, powertrain or transport track of an automation system). Functional safety depends on automatic protection and safety application operating correctly in response to inputs of e.g., safety sensors, etc., or failures with the system in a predictable manner (fail-safe). Functional safety, for example, shall prevent or at least reduce the risk of injuring people, of damaging or destroying the system or parts of it. The IEC 61508 specification series, for example, provides functional safety standards for the lifecycle of electrical, electronic or programmable electronic systems and devices and furthermore provides definitions of safety integrity levels (SILs) as relative levels of risk reduction.

Safety protocols, such as PROFlsafe, CIP safety, Safety over EtherCAT, openSAFETY, etc., which safeguards the data or messages in accordance with the safety requirements, are usually used to ensure the functional safety of an automation system, for example. They can be used in safety-related automation tasks and by safety applications up to safety integrity level 3 according to IEC 61508 specifications, for example. The transmitted safety-relevant data and safety messages are safeguarded by the safety protocol against data errors, data loss and/or transmission errors to ensure correct transmission. For this purpose, the safety protocol is provided with appropriate mechanisms, which enable possible transmission errors at least to be detected. Within the framework of the IEC 61508 specification series, the IEC 61784-3 standard - named "Industrial communication networks - Profiles - Part 3: Functional safety fieldbuses - General rules and profile definitions" - describes common principles and mechanisms that can be used in the exchange of safety-critical or safety-relevant data and/or safety messages between automation components (e.g., sensors, actuators, switches, machines, controllers, communication gateways, etc.) within a distributed automation system using a digital communication system such as a fieldbus communication system.

The principles of the IEC 61784-3 standard are based on the so-called Black channel principle, i.e., a communication system containing one or more elements without evidence of design or validation according to IEC 61508 - e.g., if communication protocols like Ethernet, Industrial Ethernet, etc. are used, for which the verification of the compliance with relevant safety requirements is not or hardly possible. The Black channel principle can be used to define safety protocols, which can be used in various industrial communication systems. The safety measures of the safety protocol, e.g., required for functional safety, are implemented as extension up application layer as so-called Safety communication layer. For example, the Safety communication layer is often inserted between the functional safety application of the respective automation component and the "non-secure" standard communication channel or communication layers (e.g., fieldbus communication system using one of the Industrial Ethernet protocols) used for the data and message transmission and exchange. The Safety communication layer, for example, corresponds to the safety level of the automation system, detects transmission errors in the underlying communication layers and can be used to check the transmitted data and/or messages for integrity. This means that the "non-secure" standard communication channel ("Black channel") is continuously monitored for integrity by a higher-level safety protocol or the Safety communication layer.

Depending on the actual safety protocol applied, different measures are provided for monitoring the integrity of the transmission of safety-related data and safety messages. Such measures may be counters, echoes, timeouts, unique sender and receiver IDs or cross checks, for example. In various existing safety protocols, Cyclic Redundancy Checks, short CRCs, are applied, as a cornerstone, to check the integrity of transmitted data and messages at a receiver's end. A CRC is an error detection method commonly used in digital communication networks to detect, if there are any erroneous bits in a message or data received in the form of data packets. The erroneous bits are detected by comparing a CRC code, which is a check value for data verification, generated at the transmitter's end and a CRC code generated at the receiver's end. This error detection method is called CRC, because the CRC code for data verification is a redundancy which expands the message without adding additional information and the algorithm to generate the CRC code is based on cyclic codes, which is a block code, where the circular shift of each codeword gives another code word that belongs to the code.

A message or data to be transmitted get the CRC code attached by the transmitter. The CRC code is relatively short - it usually has a length of a predefined number of bits - and is based on the remainder of a polynomial division of the message or data to be transmitted, using a so-called Generator polynomial or CRC polynomial. On receipt of the message, the calculation of the CRC code is repeated by the receiver using the same CRC polynomial. The newly calculated CRC code is compared with the transmitted CRC code attached to the message or to the data. In the event the CRC codes do not match, actions can be taken. In automation system, for example, the received message or data will be discarded and should be retransmitted. Additionally, an alarm (e.g., CRC alarm) will be triggered. Then, typically, the affected component or application or part of the automation system or the whole automation system will be transferred to a safe state or even stopped to guarantee safety.

Although today's Black channel principles, and CRC in particular, may guarantee safety regardless of which lower layer communication technology is used, issues may arise, especially when these methods are used in the industry or in an automation system. If, for example, the underlying communication network used (e.g., wireless networks, long cable connection using Ethernet APL, etc.) has a low transmission quality and/or a high susceptibility to interferences (e.g., noise, burst errors or other random disturbances) causing e.g., bit errors in safety messages and/or safety-relevant data. Since CRC has a quite powerful error detection capability, the errors in transmitted safety messages and/or safety-relevant data are detected with a high probability. The detection of the errors may cause CRC alarms leading to frequent safe stops. Thus, the downtime of the automation system or at least of parts of it will be increased leading to productivity issues. So, safety functions of the automation system may be turn off by an operator to avoid high downtimes and reduced productivity due to frequent CRC alarms, but turning off safety function may lead - as a consequence - to a considerable safety problem.

Theoretically, CRCs may also be used for error correction, but there is a lack of an effective decoding algorithm at the receiver's side. Usually, so called likelihood algorithms, especially maximum likelihood algorithms, are used as error correction decoding algorithms. These algorithms seek to find the transmitted message or data that maximize the likelihood of the received message or data. Even if the performance of these algorithms may be relatively good, the high decoding complexity may not be practical for the usage in reality, in particular for error correction of safety messages and/or safety-relevant data in an industrial automation system.

### SUMMARY

The objective of the present disclosure is to provide a method and system for error detection and correction of safety messages and/or safety-relevant data, which enhance the exchange of the safety messages and/or safety-relevant data between automation components in a simple way and reduce downtime of automation applications, automation components and/or the whole automation system due to CRC alarms caused by erroneous safety messages and/or safety-relevant data with little effort and costs.

These and other objectives are solved by a method and a system for error detection and correction according to the independent claims. Advantageous embodiments of the present invention are described by the dependent claims.

According to the invention, these and other objectives are achieved by a method for detecting and correcting errors as mentioned at the beginning, wherein an Error correction layer, which is inserted on the receiving automation component's side between the Safety communication layer and underlying communication layers of the communication network, carries out the following steps:
a) Retrieving a data packet from a receiving part of communication layers of the communication network, which is received by the automation component via the communication network;
b) Generating an error pattern;
c) Applying a logical operation to the received data packet and the generated error pattern, wherein an updated data packet is determined as result of the logical operation;
d) Checking the updated data packet for errors using Cyclic Redundancy Check according to a given CRC polynomial and setting an error signal to a value indicating, whether there is at least one error in the updated data packet or the updated data packet is error-free;
e) Evaluating the value of the error signal and checking a number of repetitions of steps b) to e) performed on the received data packet; and
and repeating steps b) to e), until either the value of the error signal indicates that the updated data packet is error-free or the number of repetitions of steps b) to e) have reached a predefined maximum number of repetitions.

The main aspect of the proposed solution is that the probability of CRC alarms is largely reduced, in particular when the underlying communication network has a poor transmission quality and/or a high susceptibility to error due to e.g., noise, bursts, etc. Thus, the downtime of an automation applications, an automation component and/or the whole automation system may be reduced with little effort and costs. Due to the reduction of CRC alarms, the method may also reduce subsequential safety risks caused by turning off safety functions under productivity pressure. Furthermore, the Error correction layer can be inserted without any modification of the existing Safety communication layer and/or the underlying communication layers of the communication network. So, the Error correction layer and the method carried out by the Error correction layer can be easily implemented in an automation component like e.g., safety sensors, actuators, controllers, communication gateways and other devices of a network structure or of an industrial automation system and improve the transmission and exchange of safety message and/or safety-relevant data within an automation system.

In an advantageous embodiment, the current updated data packet is sent out for further processing e.g., to Safety communication layer, when either the value of the error signal indicates that the updated data packet is error-free or the number of repetitions of steps b) to e) reaches the predefined maximum number of repetitions. The error corrected updated data packet may be used by safety application in the automation component, wherein the probability that the data packet causes a CRC alarm is largely reduced.

Additionally, it may be advantageous, when an output signal is set to a first predefined value, when either the updated data packet is error-free or the number of repetitions of steps b) to e) reaches d the predefined maximum number of repetitions, and when the output signal is set to a second predefined value, as long as the value of the error signal indicates that at least one error is detected in the updated data packet and predefined maximum number of repetitions has not been reached. Ideally, the output signal is set either to the first predefined value or to the second predefined value during step e) - when the value of the error signal is evaluated and the number of repetitions of steps b) to e) performed on the received data packet is checked. In a preferred embodiment of the invention, the value 1 is used as first predefined value and the value 0 is uses as second predefined value.

In a further preferred embodiment of the invention, the error pattern is generated based on principles of Guessing Random Additive Noise Decoding or short GRAND. Guessing Random Additive Noise Decoding or GRAND is a decoding algorithm regardless whatever the coding structure. Using GRAND, a sequence of coded symbols or data can be decoded based on guessing noise or channel noise effects, in particular added noise, wherein the noise effects are ordered from most likely to least likely in terms of probability. Then, determining the coded symbols or data includes iteratively guessing new noise sequences and removing its effects from the received symbols or data. GRAND is, for example, described in the US 2019/0199473 A1 or in the paper K. R. Duffy, J. Li, and M. Medard, "Guessing noise, not code-words," in IEEE Int. Symposium on Information Theory, pp. 671-675, 2018*.*

In another advantageous embodiment of the invention, a logical inequality operation is used as logical operation to determine the updated data packet. The logical inequality operation, which is also called exclusive or (short XOR) operation, compares the retrieved data packet and the error pattern, for example bit-by-bit, whether the respective bits differ or match. The respective bit is for example set to a first value (e.g., the value 1), if and only the respective bits of the data packet and the error pattern differ, and it is for example set to a second value (e.g., the value 0), if the respective bits of the data packet and the error pattern match. This is how the updated data packet is determined bit-by- bit, for example.

Furthermore, it is favorable, if the given CRC polynomial is pre-implemented in the Error correction layer, for example, based on the knowledge of the Safety communication layer and the safety protocol used. As an alternative, the given CRC polynomial can be configured during an initiation phase of the automation component. In another advantageous embodiment, the CRC polynomial can be configured in the initiation phase of the automation component and it can be re-configured during operation of the automation component, providing an maximum of flexibility for the error detection and correction.

The objects are also achieved by a system for detection and correcting errors, wherein the Error correction layer is inserted on the receiving automation component's side between the Safety communication layer and underlying communication layers of the communication network and wherein the Error correction layer comprises functional units for carrying out the method according to the invention. The Error correction layer at least comprises an Error pattern generator unit for generating error patterns, a Bit string calculator unit for retrieving data packets from a receiving part of communication layers of the communication network and for applying a logical operation to the retrieved data packets and error patterns fed by the Error pattern generator unit to determine updated data packets, an Error detector unit for detecting errors in the updated data packets using Cyclic Redundancy Check according to a given CRC polynomial and for setting an error signal to a value indicating, whether there is at least one error in the updated data packet or the updated data packet is error-free, and an Error correction control unit for controlling the error detection and correction of the received data packets by evaluating the value of the error signal and by monitoring, whether a predefined maximum number of repetitions of steps for detecting and correcting errors in a data packet is reached.

Furthermore, the Error correction layer preferably comprises an output unit for sending out updated data packets for further processing, especially to the Safety communication layer. The updated data packets may be sent out, when the error detection and correction of a received data packet was terminated by the Error correction control unit, because either the value of the error signal indicates that the updated data packet is error-free or the predefined maximum number of repetitions was reached.

In an advantageous embodiment, the Error correction layer is implemented by a Field Programmable Gate Array or short FPGA. FPGA is a type of integrated circuit which can be programmed or re-programmed quite easily. It consists of an array of programmable logic blocks and interconnects which can be configured to realize various digital functions. FPGAs are usually used in applications, where flexibility, speed and parallel processing capabilities are required.

### BRIEF DESCRIPTION OF THE DRAWINGS

In the following, the present invention will be described in greater detail with reference to Fig-ures 1 to 3, which show exemplary, schematic and non-limiting advantageous embodiments of the invention. In the drawings:
Fig. 1 shows an exemplary system architecture of a safety communication system according to the invention;
Fig. 2 shows a possible design of the Error correction layer of the safety communication system according to the invention;
Fig. 3 shows a flowchart of a method for detecting and correcting errors in safety messages and/or safety-relevant data received in an automation component in the form of data packets, which is carried out by the Error correction layer of the safety communication system according to the invention.

### DETAILED DESCRIPTION

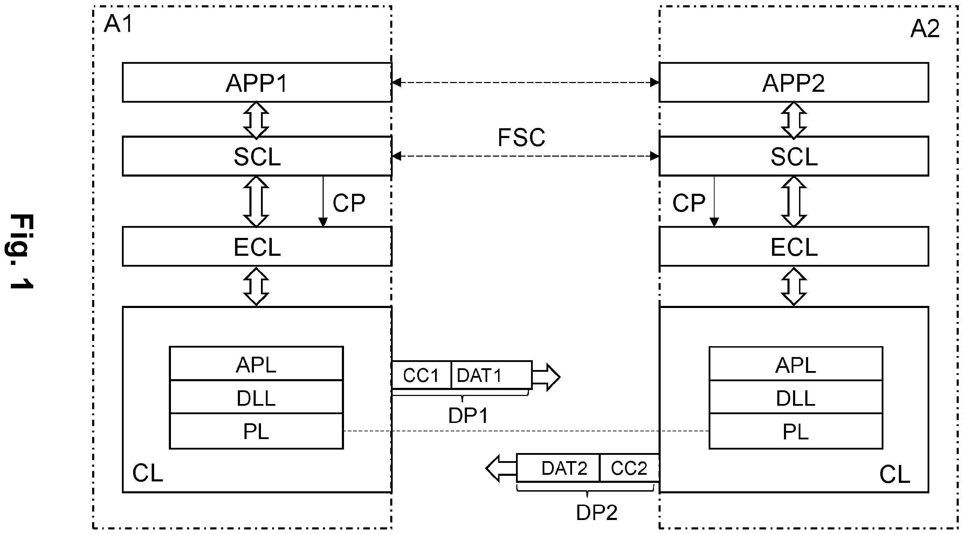

The basic idea of the invention is illustrated in Figure 1, which schematically and exemplarily shows a system architecture of a system for safety communication in an automation system with two exemplary automation components A1, A2, for the sake of convenience. The automation components A1, A2 (e.g., a sensor unit, an actuator unit, etc. communicating with a control unit, etc., which control automation tasks) exchange messages and data, especially safety-relevant messages in the form of data packets DP1, DP2 via a digital communication system like a fieldbus communication system, normally using a standard communication protocol like one of the Industrial Ethernet protocols (e.g., PROFInet, etc.). The automation components A1, A2, as shown as an example in Figure 1, are designed as transceiver units. I.e., that they can send and receive messages and/or data DP1, DP2, via the fieldbus communication system. So, a first automation component A1 (e.g., sensor unit, actuator unit, etc.) sends a first message DP1 to a second automation component A2 (e.g., control unit). The second automation component A2 sends a second message DP2 to the first automation component A2. Both messages are sent as data packets DP1, DP2, for example, wherein each data packet DP1, DP2 comprises at least a data payload DAT1, DAT2 (e.g., safety-relevant data) and a CRC code CC1, CC2 attached to the data payload DAT1, DAT2. The respective CRC code CC1, CC2 was generated using the CRC method at the automation component A1, A2 sending the respective data packet DP1, DP2. However, it is also possible that one of the two automation components A1, A2 only sends messages and/or data DP1, DP2 and the other of the two automation components A1, A2 only acts as a receiver of the messages and/or data DP1, DP2.

The communication protocol of the fieldbus communication system, as mentioned before, follows the well-known ISO/OSI-model using communication layers CL of the seventh-layer architecture of the ISO/OSI-model. Usually, an Industrial Ethernet protocol, like e.g., PROFInet, uses the Physical Layer PL (Layer 1), the Data Link Layer DLL (Layer 2) and the Application Layer APL (Layer 7), wherein the Physical Layer PL and the Data Link Layer DLL are the same for all industrial Ethernet protocols. The software used to access the fieldbus communication system runs in the Application Layer APL.

Since the automation components A1, A2, shown exemplary in Figure 1, are intended to transmit or exchange safety messages and/or safety-relevant data as data packets DP1, DP2, which are used or required by the respective functional safety applications APP1, APP2 of the automation components A1, A2, a safety protocol (e.g., PROFlsafe) is implemented for data transmission via the communication system, especially the fieldbus communication system, to safeguard the data packets DP1, DP2 in accordance with safety requirements. The safety protocol is for example implemented as extension up the Application Layer APL and represented in Figure 1 by the Safety communication layer SCL. The Safety communication layer SCL is usually placed between the function safety application APP1, APP2 of the automation component A1, A2 and the communication layers CL in the system architecture. The Safety communication layer SCL, for example, monitors the communication layers CL - the so-called "Black Channel" - for integrity of the messages DP1, DP2 transmitted.

The Safety communication layer SCL is for example inserted between the functional safety applications APP1, APP2 of the respective automation component and the "non-secure" standard communication layers CL - the so-called "Black channel", which is used by the fieldbus communication system using e.g., one of the Industrial Ethernet protocols like e.g., PROFInet. The Safety communication layer SCL, for example, corresponds to the safety level of the automation system and detects and controls transmission errors in the underlying communication layers CL. This means that the "non-secure" standard communication layers CL ("Black Channel") are continuously monitored for integrity by the safety communication layer SCL to guarantee functional safety communication FSC between the automation components A1, A2.

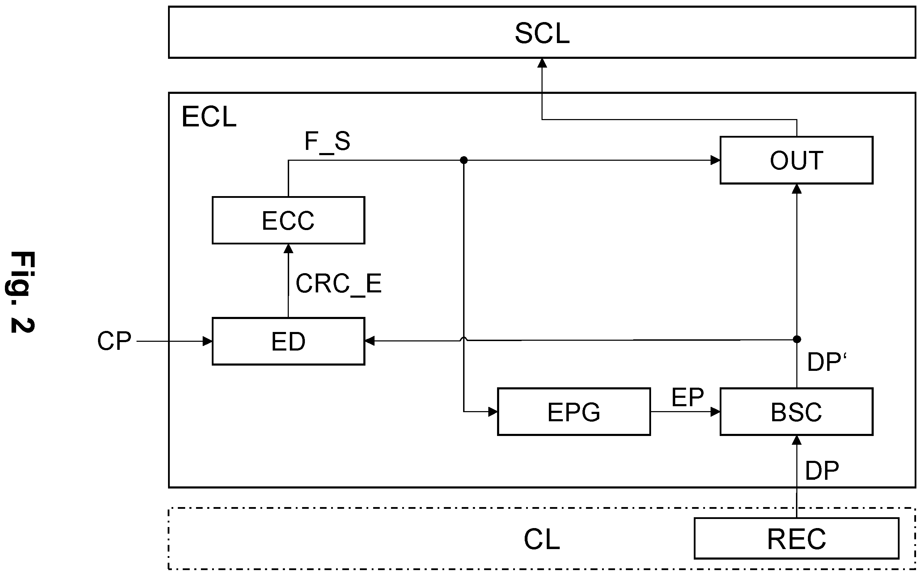

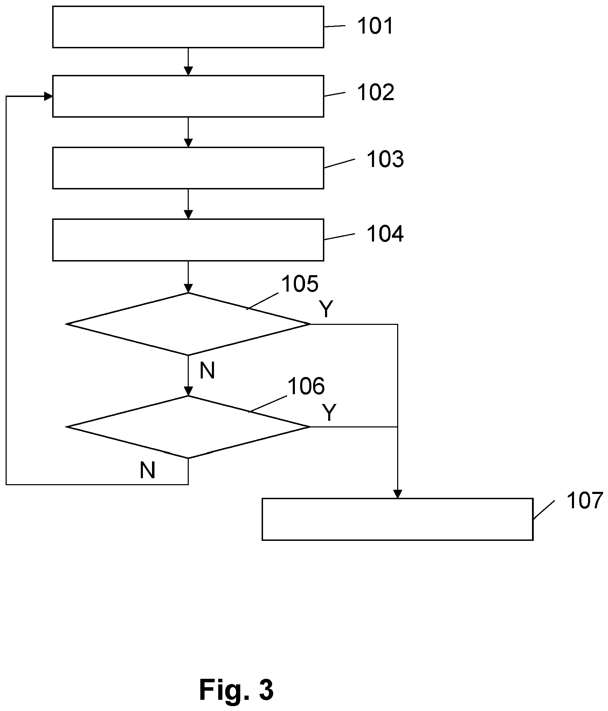

An Error correction layer ECL is also provided for safety communication via the communication network, in particular a fieldbus communication system, of the automation system in the system architecture according to the invention. The Error correction layer ECL is inserted between the Safety communication layer SCL and the underlying communication layers CL of the Black channel at the respective receiver's side. Since both automation components A1, A2, which are exemplary shown in Figure 1, are designed as transceivers, for example, both automation components A1, A2 have the Error correction layer ECL inserted in its architecture. The Error correction layer ECL does not change the design of the Safety communication layer SCL and the underlying communication layers CL of the Black channel. The Error correction layer ECL performs error correction operations to correct erroneous bits in received messages or data packets DP1, DP2 based on the knowledge of CRC polynomial CP of the Safety communication layer SCL, as explained in details blow with the aid of Figures 2 and 3. Thus, the Error correction layer ECL combines error detection and error correction in safety-relevant messages or data packets DP1, DP2 received by the automation component A1, A2. The Error correction layer ECL gets the existing dataflows, in particular the data packets DP1, DP2 received by the respective automation component A1, A2, as input from the receiving part REC of the Communication layers CL of the Black channel.

In addition to the existing dataflow or the received data packets DP1, DP2, the Error correction layer ECL needs information on the CRC polynomial CP, which is used for the error detection based on the CRC, short for Cycle Redundancy Check, from the Safety communication layer SCL. In one embodiment, the CRC polynomial CP may be pre-implemented in the Error correction layer ECL based on information on the Safety communication layer SCL or the safety protocol used in the digital communication network, in particular in the fieldbus communication system. Standard protocols for data transmission in communication system such as one of the Industrial Ethernet protocols used by a communication system of an industrial automation system and/or the safety protocols (e.g., PROFlsafe) used for safety communication may specify CRC coding schemes and certain CRC polynomial CP to be used, such as CRC-16 or CRC-32, for example. The CRC polynomial CP specified of the particular safety protocol of the communication system can be pre-implemented in the Error correction layer ECL. The CRC polynomial CP is then fixed during the execution of the error detection and correction process executed by the Error correction layer ECL. In another embodiment, the CRC polynomial CP may be configured during an initialization phase of the automation component A1, A2, e.g., based on information provided by the Safety communication layer SCL. I.e., information on the safety protocol used and the CRC polynomial CP to be used may be gathered and the respective CRC polynomial CP may be configured in the Error correction layer ECL during the initialization phase. In another, very flexible embodiment, the CRC polynomial CP may be pre-configured during the initialization phase of the automation component A1, A2, e.g., based on information provided by the Safety communication layer SCL. During the operation of the automation component A1, A2 the CRC polynomial CP may be re-configured and adapted to the error detection and correction process carried out by the Error correction layer ECL.

Figure 2 schematically shows an exemplary design of the error correction layer ECL, which can be implemented in a Field Programmable Gate Array or short FPGA, for example. The Error correction layer ECL comprises several functional building blocks or functional unit for carrying out the error detection and correction process for safety messages and/or safety-relevant data received by an automation component according to the method, which is described below with the help of Figure 3. The Error correction layer ECL receives the safety messages and/or safety-relevant data, which are transmitted as data packets DP via the digital communication network (e.g., fieldbus communication system). These data packets DP have the form of a bit string, for example. The Error correction layer ECL comprises a Bit string calculator unit BSC, which retrieves one of the received data packets DP as input from the receiving part REC of the communication layers CL. Furthermore, the Bit string calculator unit BSC is fed an error pattern EP as another input by an Error pattern generator unit EPG. The error pattern EP also has the form of a bit string, for example. The Bit string calculator unit BSC applies a logical operation to the retrieved data packet DP and the error pattern EP to produce an updated data packet DP'. The Bit string calculator unit BSC therefore uses a logical inequality operation - a so-called exclusive or operation or short XOR operation - as logical operation. The logical inequality operation compares the retrieved data packet DP and the error pattern EP bit-by-bit, whether the respective bits differ or not (e.g., whether the first bit of the data packet DP differs from the first bit of the error pattern EP or matches the first bit of the error pattern EP, and so on). Then the Bit string calculator unit BSC determines an updated data packet DP' as result of the logical operation.

The Error correction layer ECL comprises the Error pattern generator unit EPG to generate error patterns EP, e.g., in the form of bit strings. The generated error pattern EP is provided to the Bit string calculator unit BSC by the Error pattern generator unit EPG. The error patterns EP are generated based on the principles of Guessing Random Additive Noise Decoding (short GRAND), for example, by using a scheme of the GRAND as given in the paper M. Zhan, Z. Pang, K. Yu, J. Xu, F. Wu and M. Xiao, "Noise Error Pattern Generation Based on Successive Addition-Subtraction for GRAND-MO, " in IEEE Communications Letters, vol. 26, no. 4, pp. 743-747, April 2022*.*

Furthermore, the Error correction layer ECL comprises an Error detector unit ED, which is fed the updated data packet DP' from the Bit string calculator unit BSC. The Error detector unit ED performs error detection on the updated data packet DP'. The Error detector unit ED uses the Cyclic Redundancy Check or CRC according to the given CRC polynomial CP as an error detection method. The CRC polynomial CP can be pre-implemented in the Error correction layer ECL, in particular in the Error detector unit ED, for example. Alternatively, it may be configured in the Error correction layer ECL, in particular in the Error detector unit ED, during the initialization phase, e.g., based on information from the Safety communication layer SCL or it can be re-configured during the execution. The Error detector unit ED is also set up to set an error signal CRC_E to a value, which indicates, whether there is at least one error in the updated data packet DP' or not. The error signal CRC_E is the output signal of the Error detector unit ED. The error signal CRC_E may be set to a first value 0 by the Error detector unit ED, if there is no error detected in the updated data packet DP'. The error signal CRC_E may be set to a second value 1 by the Error detector unit ED, if there is at least one error detected in the updated data packet DP' fed from the Bit string calculator unit BSC.

Furthermore, the Error correction layer ECL comprises an Error correction control unit ECC. The Error correction control unit is established to control the error detection and correction process within the Error correction layer ECL. The Error correction control unit ECC receives the error signal CRC_E from the Error detector unit ED and evaluates the value of the error signal CRC_E. If the error signal CRC_E is set to the first value 0, the Error correction control unit ECC sets its output signal F_S to a first predefined value, e.g., the value 1, to stop the error detection and correction process of the received data packet DP. Furthermore, the Error correction control unit ECC also monitors the number of the repetitions of the error detection and correction process already performed on the received data packet DP. Therefore, the Error correction control unit ECC compares the current number of repetitions to a predefined maximum number of repetitions. If the current number of repetitions has reached the predefined maximum number, the Error correction control unit ECC also sets its output signal F_S to the first predefined value (e.g., 1) to stop the error detection and correction process performed on the received data packet DP.

If the error signal CRC_E received from the Error detector unit ED is set to the first value 1, the Error correction control unit ECC sets its output signal F_S to a second predefined value, e.g., the value 0. The error detection and correction process performed on the received data packet DP is continued, until either the predefined maximum number of repetitions is reached or the Error detector unit ED provides an error signal CRC_E with the value 0. I.e., as long as neither the predefined maximum number of repetitions is reach nor the value of the error signal is set to the second value 0, a new error pattern is generated by the Error pattern generator unit EPG, the newly generated Error pattern is fed to the Bit string calculator unit BSC, which produces a new updated data packet DP' from the received data packet DP and the newly generated error pattern EP, and the new updated data packet DP' is checked by the Error detector unit ED. The Error correction control unit ECC thus controls the error detection and correction process of a received data packet DP - by setting its output signal F_S to either to the first predefined value or to the second predefined value.

Furthermore, the Error correction layer ECL comprises an output unit OUT, which sends the updated data packet DP' to the Safety communication layer, when the output signal F_S of the Error correction control unit ECC is set to the first predefined value, e.g., to the value 1. As long as the output signal F_S has the second predefined value, e.g., the value 0, the output unit OUT is prevented from sending out the updated data packet DP' by the Error correction control unit ECC.

Figure 3 shows a flowchart for a method for error detection and correction in safety messages received in an automation component in the form of data packets, which is performed by the Error correction layer of the safety communication system according to the invention.

The illustrated method, as exemplary shown in Figure 3, begins with receiving step 101. During the receiving step 101, the automation component A1, A2 receives a safety message or safety-relevant data in the form of data packets DP via the communication network. The Bit string calculator unit BSC retrieves one of the received data packets DP from the receiving part REC of the communication layers CL of the Black channel, e.g., in the form of a bit string. The receiving step 101 may be performed using techniques known in the art for receiving or retrieving data packets DP from a channel of a digital communication system, especially a fieldbus communication system.

The method continues with a pattern generation step 102. The Error pattern generator unit EPG generates an error pattern EP and feeds it to the Bit string calculator unit BSC. The error pattern EP is produced by the Error pattern generator unit EPG, for example, as a bit string. Furthermore, the Error pattern generator unit EPG uses the GRAND principles to generate the new error pattern EP, which may be used to decode e.g., linear block codes based on guessing the channel noise effects according to their probability. The Error pattern generator unit EPG may especially use GRAND principles as given in the paper M. Zhan, Z. Pang, K. Yu, J. Xu, F. Wu and M. Xiao, "Noise Error Pattern Generation Based on Successive Addition-Subtraction for GRAND-MO, " in IEEE Communications Letters, vol. 26, no. 4, pp. 743-747, April 2022*,* for example.

After having retrieved the data packet DP from the receiving part REC of the communication layers CL and after being fed the error pattern EP, the Bit string calculator unit BSC produces an updated data packet DP' in a calculating step 103. In the calculating step 103 the Bit string calculator unit BSC uses a logical operation to produce the updated data packet DP' from the received data packet DP and the error pattern EP received from the Error pattern generator unit EPG. The logical operation used by the Bit string calculator unit BSC is the logical inequality operation - the so-called exclusive or operation or short XOR. The received data packet DP and the error pattern EP are compared bit-by-bit, whether the respective bits do differ or not. The result of the logical inequality operation used on the inputs DP, EP during the calculating step 103 is the updated data packet DP'.

The method then continues with an error detecting step 104. In the error detecting step 104 the Error detector unit ED receives the updated data packet DP' from the Bit string calculator unit BSC and checks the updated data packet DP' for errors. The Error detector unit ED performs an error detection on the updated data packet DP' using CRC according to the given CRC polynomial CP. I.e., the Error detector unit ED determines a CRC code of the updated data packet DP' using the given CRC polynomial CP for the polynomial division of the updated data packet DP' and compared the determined CRC code of the updated data packet DP' with an CRC code CC1, CC2 attached to the data packet DP'. In the event the CRC codes do not match, the Error detector unit ED recognizes that there is at least one error in the updated data packet DP' and sets the error signal CRC_E to a value, (e.g., the value 1) that indicates an erroneous data packet DP'. In the event the CRC codes match, no error is detected in the updated data packet DP' and the Error detector unit ED sets the error signal CRC_E to the second value (e.g., the value 0) indicating an error-free data packet DP'. At the end of the error detecting step 104 the error signal CRC_E is forwarded to the Error correction control unit ECC as an output signal of the Error detector unit ED.

The Error correction control unit ECC controls the error detection and correction process within the Error correction layer ECL, in particular with performing two decision steps 105, 106. In a first decision step 105 the Error correction control unit ECC evaluates the value of the error signal CRC_E forwarded by the Error detector unit ED. If the Error correction control unit ECC determines in the first decision step 105, that the value of the error signal CRC_E indicates that no error was detected in the updated data packet DP' (e.g., the value of the error signal CRC_E is 0), the Error correction control unit ECC sets its output signal F_S to the first predefined value, e.g., the value 1. The first predefined value of the output signal F_S stops the error detection and correction process performed on the currently received data packet DP and triggers an output step 107. In the output step 107 the current updated data packet DP' is sent out, for example to the Safety communication layer SCL, by the output unit OUT. Then the error detection and correction process can be started again with the next data packet DP received via the communication network and with the receiving step 101.

If the Error correction control unit ECC determines in the first decision step 105, that the value of the error signal CRC_E indicates that there was at least one error detected in the updated data packet DP' (e.g., the value of the error signal CRC_E is 1), the Error correction control unit ECC sets its output signal F_S to the second predefined value (e.g., the value 0). I.e., that the process is continued with a second decision step 106. In the second decision step 106 the Error correction control unit ECC checks, whether the predefined maximum number of repetitions of the error detection and correction process is reached. If the current number of repetitions has reached the predefined maximum number, the Error correction control unit ECC also sets its output signal F_S to the first predefined value, e.g., the value 1, to stop the error detection and correction process performed on the currently received data packet DP. The process is ended with the output step 107. I.e., the current updated data packet DP' is sent out by the output unit OUT to the Safety communication layer SCL, for example, and the process starts with receiving step 101 again, wherein the Bit string calculator unit BSC retrieves the next data packet DP for error detection and correction from the receiving part REC of the communication layers CL.

If the value of the error signal CRC_E indicated that there is at least one error in the updated data packet DP' (e.g., is 1) and the Error correction control unit ECC determines in the second decision step 106 that the predefined maximum number of repetitions has not been reached yet, the Error correction control unit ECC sets its output signal F_S to the second predefined value, e.g., the value 0, whereby the output step 107 is blocked and the error detection and correction process on the currently received data packet DP is continued. I.e., that the pattern generation step 102, the calculating step 103, the error detecting step 104 and the decision steps 105, 106 are repeated with the currently received data packet DP, until either the error signal CRC_E is set to the value 0 (i.e., no error was detected in the currently checked updated data packet DP') or the predefined maximum number of repetitions is reached. If one of these two criteria is met, the error detection and correction process of the currently received data packet DP is stop by setting the output signal F_S of the Error correction control unit ECC to the first predefined value (e.g., the value 1) and by performing the output step 107. The error detection and correction process can be started again with the receiving step 101 retrieving the next data packet DP received via the communication network.

## Claims

1. Method for detecting and correcting errors in safety messages and/or safety-relevant data received by an automation component (A1, A2) of an industrial automation system via a digital communication network, especially via a fieldbus communication system, wherein a safety protocol, which is implemented by means of a Safety communication layer (SCL), is used for data transmission of the safety messages and/or safety-relevant data, wherein Cyclic Redundancy Checks are applied to the safety messages and/or safety-relevant data, and wherein the safety messages and/or safety-relevant data are transmitted in the form of data packets (DP, DP1, DP2), ***characterized in, that*** an Error correction layer (ECL), which is inserted on the receiving automation component's (A1, A2) side between the Safety communication layer (SCL) and underlying communication layers (CL) of the communication network, carries out the following steps:
a) Retrieving a data packet (DP, DP1, DP2) from a receiving part (REC) of communication layers (CL) of the communication network, which is received by the automation component (A1, A2) via the communication network (101);
b) Generating an error pattern (EP) (102);
c) Applying a logical operation to the received data packet (DP, DP1, DP2) and the generated error pattern (EP), wherein an updated data packet (DP') is determined as result of the logical operation (103);
d) Checking the updated data packet (DP') for errors using Cyclic Redundancy Check according to a given CRC polynomial (CP) and setting an error signal (CRC_E) to a value indicating, whether there is at least one error in the updated data packet (DP') or the updated data packet (DP') is error-free (104);
e) Evaluating the value of the error signal (CRC_E) and checking a number of repetitions of steps b) to e) performed on the received data packet (DP) (105, 106);
and repeating steps b) to e), until either the value of the error signal (CRC_E) indicates that the updated data packet (DP') is error-free or the number of repetitions of steps b) to e) reaches a predefined maximum number of repetitions.

2. Method according to claim 1, ***characterized in, that*** the current updated data packet (DP') is sent out for further processing (107), when either the value of the error signal (CRC_E) indicates that the updated data packet (DP') is error-free or the number of repetitions of steps b) to e) reaches the predefined maximum number of repetitions.

3. Method according to any one of the previous claims, ***characterized in, that*** an output signal (F_S) is set to a first predefined value (105, 106), when either the updated data packet (DP') is error-free or the number of repetitions of steps b) to e) reaches d the predefined maximum number of repetitions, and the output signal (F_S) is set to a second predefined value (105, 106), as long as the value of the error signal (CRC_E) indicates that at least one error is detected in the updated data packet (DP') and predefined maximum number of repetitions has not been reached.

4. Method according to any one of the previous claims, ***characterized in, that*** the error pattern (EP) is generated based on principles of Guessing Random Additive Noise Decoding or GRAND.

5. Method according to any one of the previous claims, ***characterized in, that*** a logical inequality operation is used as logical operation to determine the updated data packet (DP').

6. Method according to any one of the previous claims, ***characterized in, that*** the given CRC polynomial (CP) is either pre-implemented in the Error correction layer (ECL) or is configured during an initiation phase of the automation component (A1, A2) or is re-configured during operation of the automation component (A1, A2).

7. System for detecting and correcting errors in safety messages and/or safety-relevant data received by an automation component (A1, A2) of an industrial automation system via a digital communication network, especially via a fieldbus communication system, wherein a safety protocol, which is implemented by means of a Safety communication layer (SCL), is used for data transmission of the safety messages and/or safety-relevant data, wherein Cyclic Redundancy Checks are applied to the safety messages and/or safety-relevant data, and wherein the safety messages and/or safety-relevant data are transmitted in the form of data packets (DP, DP1, DP2), ***characterized in, that*** an Error correction layer (ECL) is inserted on the receiving automation component's (A1, A2) side between the Safety communication layer (SCL) and underlying communication layers (CL), wherein the Error correction layer (ECL) at least comprises:
- an Error pattern generator unit (EPG) for generating error patterns (EP);
- a Bit string calculator unit (BSC) for retrieving data packets (DP, DP1, DP2) from a receiving part (REC) of communication layers (CL) of the communication network and for applying a logical operation to the retrieved data packets (DP, DP1, DP2) and error patterns (EP) fed by the Error pattern generator unit (EPG) to determine updated data packets (DP');
- an Error detector unit (ED) for detecting errors in the updated data packets (DP') using Cyclic Redundancy Check according to a given CRC polynomial (CP) and for setting an error signal (CRC_E) to a value indicating, whether there is at least one error in the updated data packet (DP') or the updated data packet (DP') is error-free; and
- an Error correction control unit (ECC) for controlling the error detection and correction in the received data packets (DP, DP1, DP2) by evaluating the value of the error signal (CRC_E) and by monitoring, whether a predefined maximum number of repetitions of steps for detecting and correcting errors in a data packet (DP, DP1, DP2) is reached.

8. System according to claim 7, ***characterized in, that*** furthermore the Error correction layer (ECL) comprises an output unit (OUT) for sending out updated data packets (DP').

9. System according to one of claims 7 to 8, ***characterized in, that*** the Error correction layer (ECL) is implemented by a Field Programmable Gate Array.
